# EUROPEAN PATENT APPLICATION

(11) **EP 1 296 382 A1**
(43) Date of publication of application: **26.03.2003**
(21) Application number: 01830600.1
(22) Date of filing: 21.09.2001
(51) Int. Cl.: H01L 31/048, E04D 13/18

(54) **Method to integrate a photovoltaic panel onto a lean-to roof**

(71) Applicant: Gambale Srl, 44043 Mirabello (Ferrara) (IT)
(72) Inventor: Gambale, Vittorio, 44043 Mirabello (Ferrara) (IT)
(74) Representative: Dalle Nogare, Roberto

(57) **Abstract**

The complex consists of a big tile (1) onto which is to be constrained by its outside pofile a photovoltaic panel (2). Said big tile (1) has its outside profile (1a) of equal profile shape of the conventional tiles with central bending toward (1b) over ending with a flat part (1c) for leanig of the photovoltaic panel (2) and it has in its central part a flat base (1h) realized for at most permitting the heat disposal so to have the working of the panel (2) in the optimum conditions. For the solidarily fixing panel-tile hexagonal-head bolt (3) are used drowned and integral that permit the blocking with suitable hexagonal-head nuts (4), said blocking made by "L"-shape element (5) to fix the downstream border (2a) of the panel (2) and by flat element (6) to fix the panel upriver border (2b) or to make the coupling of two or more panels (2).

## Description

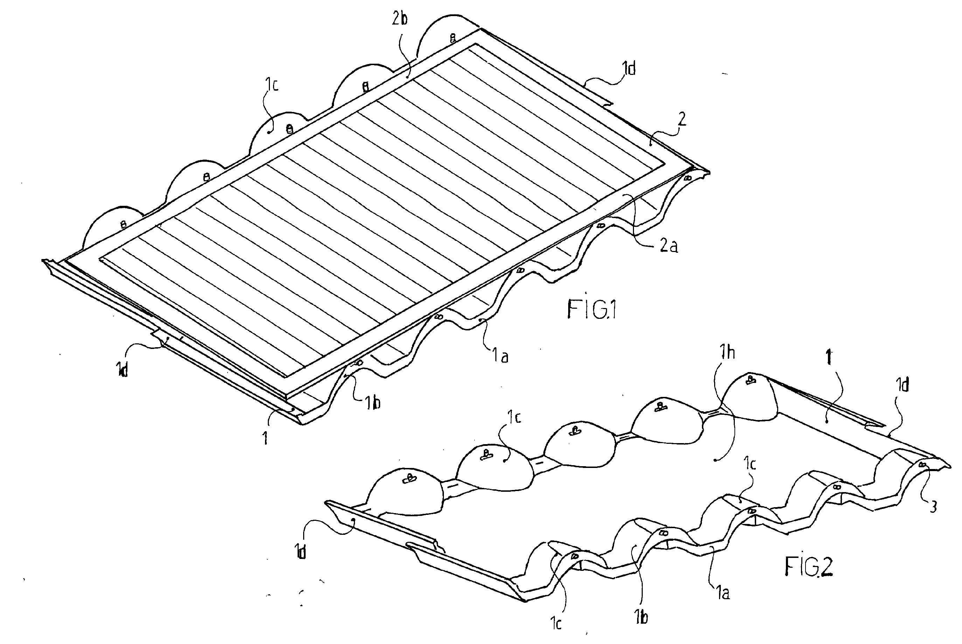

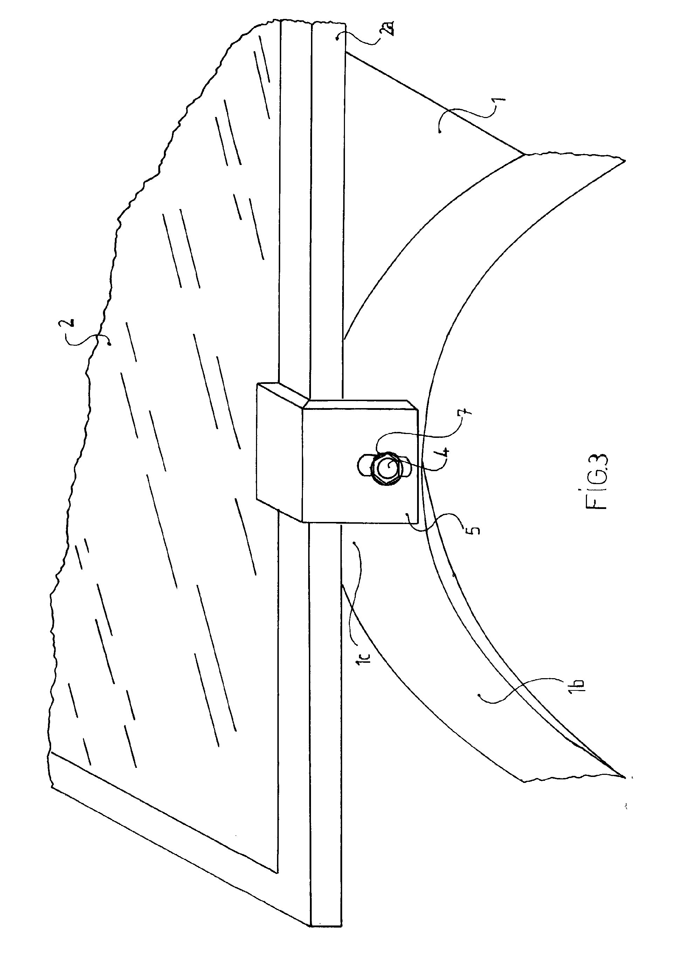

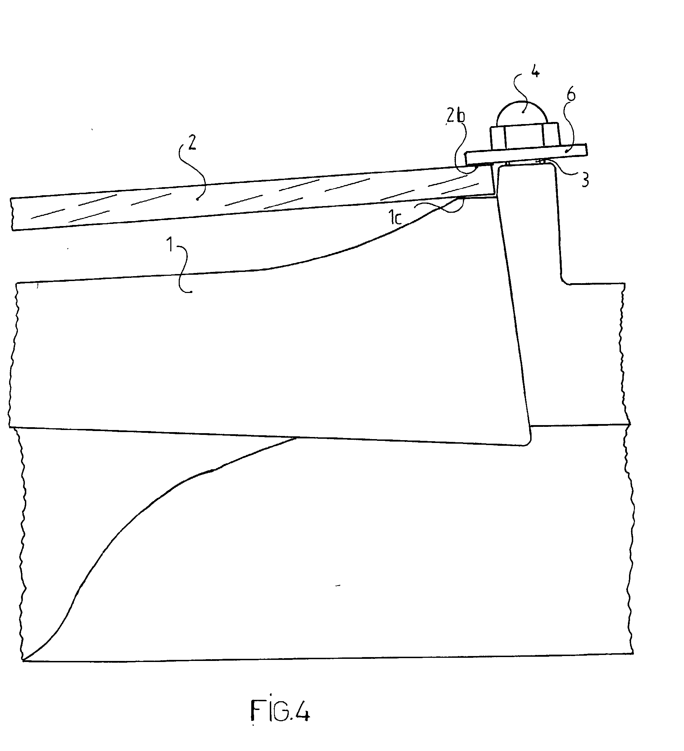

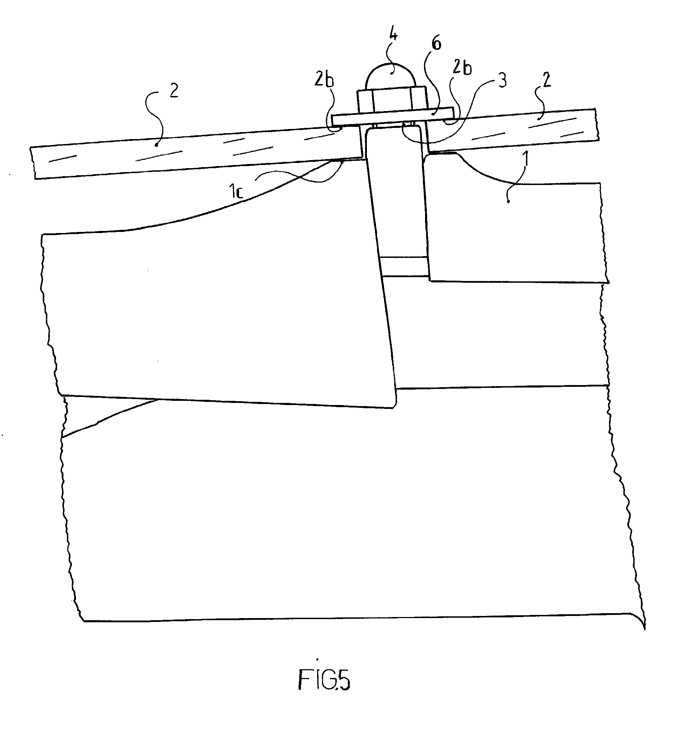

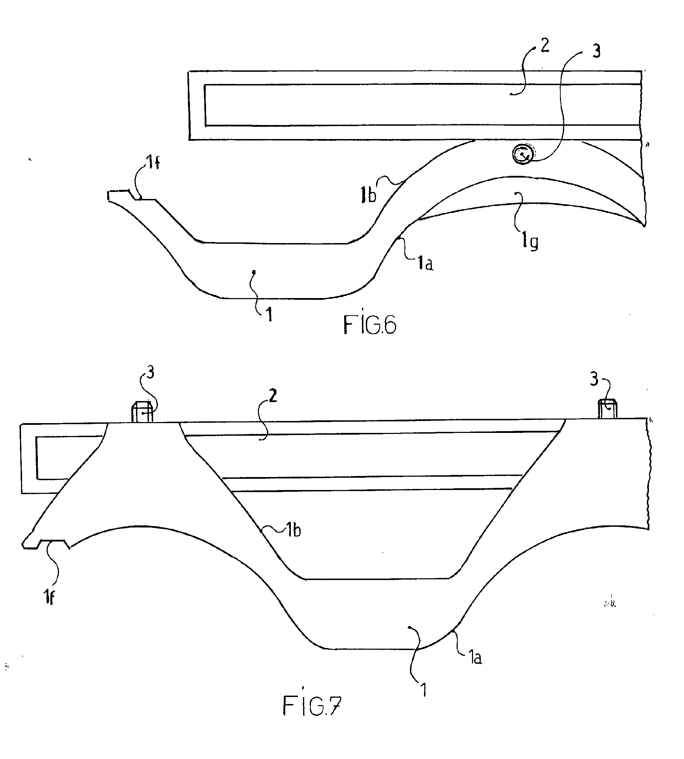

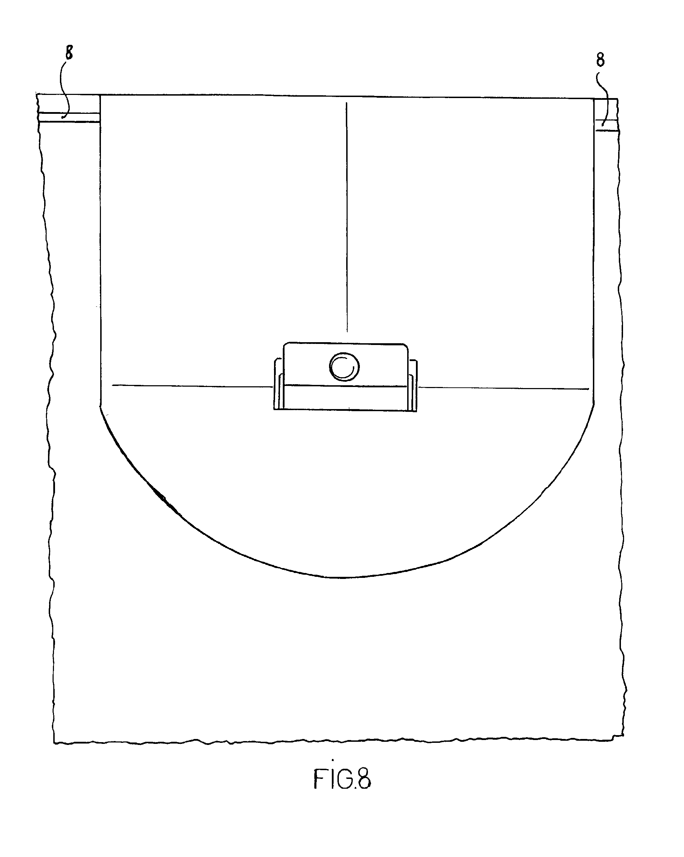

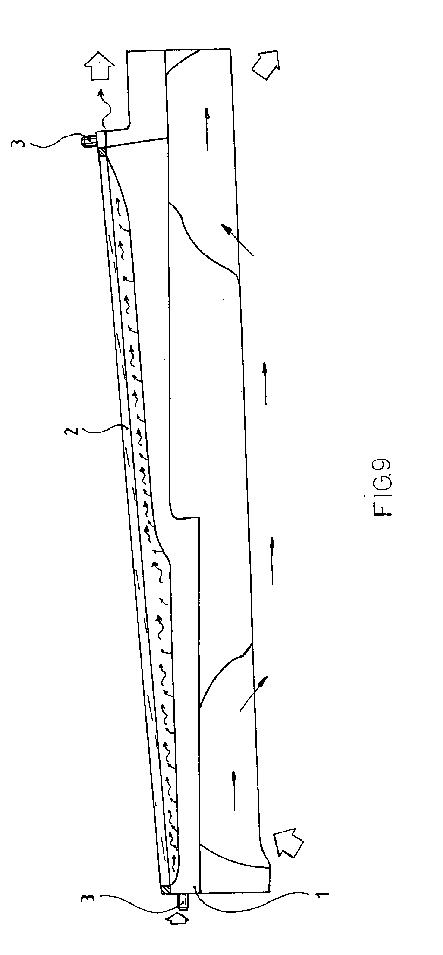

The invented method refers to a new method in the sector of the coverings for roofs that must support photovoltaic panels and in particular in the sector using for these coverings high section tiles, i.e. sections with a height from two centimetres on. The known art provides a more and more growing use of the photovoltaic panels for clean energy production. Said panels replace the conventional sources of power that as known pollute the environment and have costs very high for the production of the same energy and for the upkeep of the plants. The use of photovoltaic panels is to be very favourable in particular in those countries where their use and their efficiency are facilitated to the climatic conditions. The prior art provides the mounting of said photovoltaic panels by fixing with brackets or other bearing structures raised in comparison with the roofs, or to the tiles of roofs, providing the boring of the carrying structures for the connection of the supporting means of said panels. These current connection methods damage the roof impermeability owing to the holes necessary in the conventional mouting methods; they reduce the efficiency of the photovoltaic panels owing to the absence of air circulation under the same panels. Moreover the known methods have not the caracteristic of the integration of the photovoltaic panels with the roof as said panels are mounted with stirrups fixed over the tiles, sometimes with different angles in comparison with the ones of the roofs, so compromising the panel stability, above all it is subjected to heavy draught, besides to worsen the covering look in particular in the building with high architectonic interest. Summarizing the current mouting methods have: 1) no integration between the covering and the panel, 2) high costs both for the mounting than for the upkeep, 3) use of panels not suitable as is used a standard product being impossible, owing to the exorbitant costs, to provide a specific panel for each kind of covering, 4) lower efficiency of the panels owing to air circulation missing with consequent overheating of the same panel. Foundamental feature is that, different from other applications and in spite of the smallest overhang to obtain the bigger architectonic integration of the panel with the roof, the invented method has been studying both from the fluid dynamic point of view both from the thermodinamic one so to obtain a cooling such to permit to the photovoltaic panel to operate in temperature optimum conditions. Infact it is known that the fotovoltaic panel efficiency is connected to the temperature: more this is high less is the panel efficiency. The photovoltaic panel cooling and the cooling of all the complex, to be obtained exploiting the draught microcirculation of the roof and the air circulation licking the panel, is foundamental characteristic of the invented method. Other foundamental feature of the invented method is given by used material to produce the big tile (or rather it has dimension ten times bigger than one of the conventional tile) supporting the photovoltaic panel and that then comes to form the roof covering. In particular to obtain a supporting tile for the photovoltaic panel which was formed by only one body, so to 1) avoid infiltrations, 2) have a better mounting facility, 3) create a less load on the roof and 4) to determine a better handiness, it is used for the tile manufacturing a new material for the roof covering sector. Said material consists of a glass reinforced concrete mixture, that is a concrete mixture reinforced with glass fiber with alkali resistance characteristics and to other additives. The invented mixture have the following characteristics: 1) it is 20% lighter than the conventional materials, 2) it permits to realize manufactures with thickness twice thiner in comparison with the thickness used in the conventional concrete mixture such it has a triple time bending strenght. All this permits at a parity of strenght, in spite of the size of the panel-holder big tile,' to have thickness similar to that of the conventional tiles. Moreover, the glass fiber presence into the mixture, permits to have not the fragility typical of the products made of concrete or in other conventional materials used in covering sector. The invented tile is then produced with multiple sizes compared to the sizes of a standard tile so having the same modularity and so permitting a perfect integration into any point of the covering. The invented method provides a big tile 1, to be obtained for melting into molds with reinforced glass concrete mixture, onto which is to be constrained by its outside profile a photovoltaic panel 2. Said big tile 1 has its outside profile 1a of equal profile shape of the conventional tiles with central bending toward 1b over ending with a flat part 1c on which the photovoltaic panel 2 is leant. The side walls 1d permit the assembling of the big tile 1 with the conventional tiles used in the covering of the rest of the roof with total continuity thanks to their joint profile 1f complementary to that of the tiles. Moreover underlying the outisde bending 1b a detent 1g is provided, so to fix the panel-tile in permanent way to the supporting structure of the tiles. The tile 1 is then characterized in its central part by a flat base 1h realized for at most permitting the heat disposal so to have the working of the panel 2 in the optimum conditions. For determining a solidarily fixing panel-tile hexagonal-head bolt 3 are used drowned and integral that permit the blocking with suitable exagonal-head nuts 4. Said blocking makes by "L"-shaped element 5 to fix the downstream border 2a of the panel 2 and by flat elements 6 to fix the panel upriver border 2b or to make the coupling of two or more panels 2. Said fixing system keeps the panels 2 raised in comparison with the flat base 1h of the tile so permitting, also by means of openings, the circulation of draughts for the cooling aiding the convective motion having other cooling function. In particular to fix the downstream border 2a a bolt 3 is provided to be horizontal drowned inside the tile body with holding given by nut 4 with previous disposition of a suitable washer 7. Said downed screw 3 has the function of stud and it permits to assemble by the overturned "L"-shaped element 5 and by the nut 4 the tile 1 with the downstream part of the panel 2. The fixing of the upriver border 2b of the panel 2 instead is actuated with the same screw 3 but downed in vertical inside the tile body then using the bored anodized aluminum flat element 6 for crossing of the vertical screw 3 with blocking tile/panel to be given by the nut 4. Moreover the position in sequence of more panels 2 is to be actuated with bringing in approach two tiles with the border 2b of the panel 2 on part 1c and blocking in position by the vertical drowned screw 3 on which is inserted the flat element 6 that held by the nut 4 comes to give a solidly connexion acting between the two panels 2 so permitting to cover, repeating the mounting phase, any surface of the roof. To protect the tile/panel morever is provided a relief 8 to protect in the case of rains with big angle or of rising currents. Foundamental feature of the invented tile/panel covering means is given by the fact that the cooling is to be obtained with the exploitation of the hot convective motions so having a photovoltaic panel retroventilation. Moreover the cooling is given favouring the undertile microventilation. Said microventilation by means of the rising currents and of the effect said "ventilated wall" permits to cool the complex tile/panel maintaining the architectonic integration of the parts. The tile/panel complex and the different fixing methods are illustrated in indicative way in the drawings of sheets 1, 2, 3, 4, 5, 6 and 7. In sheet 1 fig. 1 is perspective view of the tile 1 bringing the panel 2. Fig. 2 is perspective view of the single tile 1. In sheet 2 fig. 3 is view of the fixing method tile/panel using the overturned "L"-shaped element 5 to fix the downstream border 2a. In sheet 3 fig. 4 is view of the fixing of the upriver border 2b of the panel 2 with the flat element 6. In sheet 4 fig. 5 is detailed view of the fixing of two panels 2. In sheet 5 fig. 6 is view of the complex tile/panel in its downstream border before assembling of a subsequent complex. Fig. 7 is view of the upriver border of the same complex. In sheet 6 fig. 8 is particular to show the relief 8 to protect against rains and currents. In sheet 7 fig. 9 is corrent stream illustration with the arrows under the panel 2 to indicate the microcirculation and the arrows designed in the lower part of the complex tile/panel to indicate the retroventilation.

## Claims

1. Covering method to integrate a photovoltaic panel onto a lean-to roof comprising a big tile (1) onto which is to be constrained by its outside profile a photovoltaic panel (2); **characterized in that**
- said big tile (1) has its outside profile (1a) of equal profile shape of the conventional tiles with central bending toward (1b) over ending with a flat part (1c) on which the photovoltaic panel (2) is leant; and that
- the tile (1) has in its central part a flat base (1h) realized for at most permitting the heat disposal so to have the working of the panel (2) in the optimum conditions; and that
- for the solidarily fixing panel-tile hexagonal-head bolt (3) are used drowned and integral that permit the blocking with suitable eagonal-head nuts (4), said blocking makes by "L"-shaped element (5) to fix the downstream border (2a) of the panel (2) and by flat elements (6) to fix the panel upriver border (2b) or to make the coupling of two or more panels (2).

2. Covering method to integrate a photovoltaic panel onto a lean-to roof, as per claim 1, **characterized in that** the tile (1) is obtained for melting into molds with reinforced glass concrete mixture.

3. Covering method to integrate a photovoltaic panel onto a lean-to roof, as per claim 1, **characterized in that** the side walls (1d) permit the assembling of the big tile (1) with the panel with the conventional tiles with total continuity thanks to their joint profile (lf) complementary to that of the tiles; a detent (lg) is then provided so to fix the panel-tile in permanent way to the supporting structure of the tiles.

4. Covering method to integrate a photovoltaic panel onto a lean-to roof, as per claim 1, **characterized in that** the fixing system keeps the panels (2) raised in comparison with the flat base (1h) of the tile so permitting, also by means of openings, the circulation of draughts for the cooling aiding the convective motions having other cooling function.

5. Covering method to integrate a photovoltaic panel onto a lean-to roof, as per claim 1, **characterized in that** to fix the downstream border (2a) of the panel (2) a bolt (3) is provided to be horizontal drowned inside the tile body with holding given by nut (4) vith previous disposition of a suitable washer (7); said downed screw (3) has the function of stud and it permits to assemble by the overturned "L"-shaped element (5) and by the nut (4) the tile (1) with the downstream part of the panel (2).

6. Covering method to integrate a photovoltaic panel onto a lean-to roof, as per claim 1, **characterized in that** the fixing of the upriver border (2b) of the panel (2) is actuated with a screw (3) downed in vertical inside the tile body then using the bored anodized aluminum flat element (6) for crossing of the screw (3) with blocking tile/panel to be given by the nut (4).

7. Covering method to integrate a photovoltaic panel onto a lean-to roof, as per claim 1, **characterized in that** the position in sequence of more panels (2) is to be actuated with bringing in approach two tiles with the border (2b) of the panel (2) on flat part (1c) and blocking in position by the vertical drowned screw (3) on which is inserted the flat element (6) that held by the nut (4) comes to give a solidly connexion acting between two or more panels (2).

8. Covering method to integrate a photovoltaic panel onto a lean-to roof, as per claim 1, **characterized in that** a relief (8) is provided to protect the tile/panel in case of rains with big angle or of rising currents.

9. Covering method to integrate a photovoltaic panel onto a lean-to roof, as per claim 1, **characterized in that** the cooling is to be obtained with the exploitation of the hot convective motions so having a photovoltaic panel retroventilation; moreover the cooling is given favouring the undertile microventilation.
